**Europäisches Patentamt**

**European Patent Office**

**Office européen des brevets**

(11) Veröffentlichungsnummer : **0 503 272 B1**

(12) **EUROPÄISCHE PATENTSCHRIFT**

(45) Veröffentlichungstag der Patentschrift :
**27.12.95 Patentblatt 95/52**

(51) Int. Cl.⁶ : **G01R 27/26,** G01R 19/10, G01P 15/125

(21) Anmeldenummer : **92102023.6**

(22) Anmeldetag : **07.02.92**

(54) Schaltungsanordnung zur Messung des Quotienten der Kapazitätswerte zweier Kondensatoren

(30) Priorität : **08.03.91 DE 4107366**

(43) Veröffentlichungstag der Anmeldung :
**16.09.92 Patentblatt 92/38**

(45) Bekanntmachung des Hinweises auf die
Patenterteilung :
**27.12.95 Patentblatt 95/52**

(84) Benannte Vertragsstaaten :
**CH DE FR GB IT LI NL**

(56) Entgegenhaltungen :
**EP-A- 0 178 768**
**EP-A- 0 303 442**
**EP-A- 0 402 522**
**EP-A- 0 438 103**
**GB-A- 2 177 806**
**US-A- 4 458 196**
**US-A- 4 820 973**

(73) Patentinhaber : **Leica AG**
**CH-9435 Heerbrugg (CH)**

(72) Erfinder : **Van Seeters, Josephus Marinus**
**Gstaldenstrasse 8**
**CH-9442 Berneck (CH)**

EP 0 503 272 B1

**Beschreibung**

Die Erfindung betrifft eine Schaltungsanordnung zur Messung des Quotienten der Kapazitätswerte von zwei Kondensatoren mit sehr kleinen Kapazitäten, die untereinander sehr kleine Differenzen aufweisen und die mit ihrer einen Elektrode zusammengeschaltet sind sowie die Verwendung der Schaltungsanordnung bei einem Sensor. Als klein sollen Kapazitäten im Pico-Farad-Bereich und Kapazitätsunterschiede bis in den Femto-Farad-Bereich angesehen werden.

Eine Schaltungsanordnung zur Messung des Quotienten der Kapazitätswerte von zwei miteinander zu vergleichenden und an einer Elektrode zusammengeschalteten Kondensatoren ist aus der DE 36 23 136 C2 bekannt. Die Kondensatoren sind signalausgangsseitig zusammengeschaltet. Ein Gleichspannungsignal wird über einen Schalter der freien Elektrode des einen Kondensators zugeführt und über einen Operationsverstärker und einen weiteren Schalter der freien Elektrode des anderen Kondensators zugeführt. Die beiden Schalter werden gegenphasig geschaltet. Ausserdem ist dem Operationsverstärker ein weiterer Schalter vorgeschaltet, der gegenüber den anderen Schaltern zeitverzögert öffnet. Während der Öffnungszeit dieses Schalters fließen Ströme aus den beiden Kondensatoren durch den Schalter vor dem Operationsverstärker. Der mittlere Strom während dieser Zeit ist gleich Null. Daraus ergibt sich, daß das Verhältnis der Eingangsspannungen der Kondensatoren proportional zu ihren Kapazitäten ist.

Das bekannte Verfahren ist wegen der Verwendung der Vielzahl von Schaltern insbesondere bei der Messung von sehr kleinen Kapazitäten mit Mängeln behaftet. Die Steuersignale der Schalter führen zu geringen Strömen, die in der gleichen Größenordnung liegen wie die der durch die Kapazitäten fließenden Ströme und sie sind temperaturabhängig. Ein Nachteil wurde auch darin gesehen, daß der Annahme über den mittleren Strom eine Zeitmessung zugrundeliegt.

Die vorgenannte Schrift offenbart eine Weiterbildung mit einer reinen Spannungsmessung am Ausgang des Operationsverstärkers. Die beiden Kondensatoren werden abwechselnd in die Meßschaltung eingeschaltet. Die Frequenz der Signalspannung kann bis in die Größenordnung von 300 kHz gewählt werden und ist begrenzt durch die Ansprechzeit der Analogschalter. Bei Kenntnis der Kapazität eines der Kondensatoren als Bezugswert und Messung der Signalausgangswerte am Operationsverstärker sollen die andere Kapazität oder ihre Änderung in empfindlicher Weise bestimmt werden können. Über die untere Grenze der meßbaren Kapazitäten sind keine Angaben offenbart.

Die Messung von Kapazitäten im Pico-Farad-Bereich ist z.B zur Charakterisierung von integrierten Schaltkreisen der MOS- oder MIS-Technologie erforderlich. Hierbei muß zusätzlich die Kapazität über einen weiten Frequenzbereich von einigen Herz bis zu einigen Megaherz gemessen werden. Eine geeignete Schaltungsanordnung ist in EP 0 381 596 A1 angegeben.

Das Ersatzschaltbild eines integrierten Schaltkreises ist eine Parallelschaltung aus Kapazität und Widerstand, dessen Größe nicht vernachlässigbar ist. Zur Messung der Impedanz wird an das Bauelement eine Gleichspannung variabler Amplitude und eine überlagerte Wechselspannung variabler Frequenz gelegt. Das Wechselspannungssignal ist vorzugsweise ein Dreiecksignal. Das Ausgangssignal wird über einen rückgekoppelten Operationsverstärker in ein Wechselstromsignal gewandelt. Die Dachneigung und die Amplitude dieses Wechselstromsignals in einem definierten Meßzeitpunkt werden bestimmt. Aus der Amplitude wird dann die Größe der Kapazität und aus der Dachneigung die des parallelen Widerstandes abgeleitet. Zur Absolutmessung kann abwechselnd ein bekannter Schaltkreis als Referenz in die Meßanordnung eingefügt werden.

Die direkte Messung des Verhältnisses der Kapazitäten zweier unbekannter Kondensatoren ist mit dieser Schaltung nicht möglich.

Auf der Feststellung kleiner Kapazitätsänderungen in Kondensatorsystemen sehr kleiner Kapazitäten beruht das Meßprinzip einiger Sensoren für Neigungs- und/oder Beschleunigungsanzeigen. Ein solcher Sensor und eine geeignete Auswerteschaltung sind in der DE-PS 25 23 446 beschrieben. Der Sensor besteht aus zwei einander in festem Abstand gegenüberstehenden Elektrodenplatten, zwischen denen sich eine federnd aufgehängte Kondensatorplatte befindet.

Die beiden Elektrodenplatten werden mit einem Generator für die Erzeugung einer Wechselspannung verbunden, so daß sich an den Elektrodenplatten um 180° gegeneinander phasenverschobene Spannungen mit gleicher Amplitude und Frequenz befinden. Somit heben sich die auf die Kondensatorplatte wirkenden Spannungen gegenseitig auf, wenn sich die Kondensatorplatte genau zwischen den Elektrodenplatten befindet. Weicht die Kondensatorplatte unter dem Einfluß der Gravitation oder von Trägheitskräften aus ihrer Nullage aus, so entsteht durch die Änderung der Kapazitäten zwischen den Elektrodenplatten und der Kondensatorplatte an dieser eine Wechselspannung.

Die Kondensatorplatte steht in elektrischer Verbindung mit einem Meßwertumformer, in dem diese Wechselspanung in ein Meßsignal zur Anzeige der Winkeländerung der Lage des Sensors umgeformt wird. Die Wechselspannung kann jedoch auch einem Regler zugeführt werden, der daraus ein geregeltes Gleichspannungssignal erzeugt, das der an den Elektrodenplatten anliegenden Wechselspannung überlagert wird. Die Regelung ist so ausgelegt, daß die Kondensatorplatte entgegen der auf sie einwirkenden Kraft in ihrer Nullage gehalten wird. Aus den Gleichspannungs-Regelsignalen kann dann ebenfalls die der Neigung und/oder Beschleunigung proportionale Winkeländerung der Kondensatorplatte bestimmt werden.

Die in dem Sensor zu detektierenden Kapazitätsänderungen sind sehr gering, so daß parasitäre Kapazitäten und Leckwiderstände der Anschlußdrähte und anderer Bauelemente der für den Schaltungsaufbau verwendeten Platine die Genauigkeit und Empfindlichkeit entscheidend beeinflussen. Die Regelung auf die Nullage ist sehr aufwendig. Da die für die Rückführung der Kondensatorplatte aufzuwendende Gleichspannung relativ hoch sein muß, ergeben sich zusätzliche Isolationsprobleme und besondere Anforderungen an die mechanische Konstruktion des Sensors.

Aus der EP-A-0 303 442 ist eine Anordnung zur Messung des Quotienten von zwei Kapazitätswerten bekannt, bei der ein Oszillator in Abhängigkeit von den zu messenden Kapazitäten mit unterschiedlichen Frequenzen schwingt. Die beiden Kapazitäten werden nacheinander sowohl einzeln als auch in Parallelschaltung in den Schwingkreis des Oszillators eingeschaltet, so daß mit der Grundfrequenz des Oszillators insgesamt vier verschiedene Frequenzen am Ausgang des Oszillators gemessen werden können. Der gesuchte Quotient der beiden Kapazitätswerte ergibt sich durch an sich bekannte Verknüpfung der vier unabhängig voneinander gemessenen Frequenzwerte.

Aufgabe der Erfindung ist es, eine Schaltungsanordnung anzugeben, mit der in direktem Vergleich das Verhältnis der Werte zweier Kapazitäten ermittelt werden kann, die unempfindlich gegenüber dem Schaltungsaufbau ist, bei der bereits über wenige Meßzyklen eine sehr große Genauigkeit erreicht werden kann und die über einen großen Meßbereich linear arbeitet. Sie soll mit handelsüblichen elektronischen Bauelemente preisgünstig realisierbar sein.

Diese Aufgabe wird bei einer Schaltungsanordnung der eingangs genannten Art durch die kennzeichnenden Merkmale der Ansprüche 1 oder 2 gelöst. Vorteilhafte Ausgestaltungen ergeben sich aus den Merkmalen der Ansprüche 3 und 4. Eine vorteilhafte Verwendung der Schaltungsanordnung ist in den Ansprüchen 5 und 6 angegeben.

Die erfindungsgemäße Schaltungsanordnung und ihre Verwendung in einem Neigungs- und/oder Beschleunigungssensor sind in der Zeichnung schematisch dargestellt und werden anhand der dargestellten Ausführungsbeispiele näher erläutert.

Es zeigen:

Fig. 1      die Schaltungsanordnung,

Fig. 2      ein Signalimpuls-Diagramm und

Fig. 3      einen kapazitätsändernden Sensor.

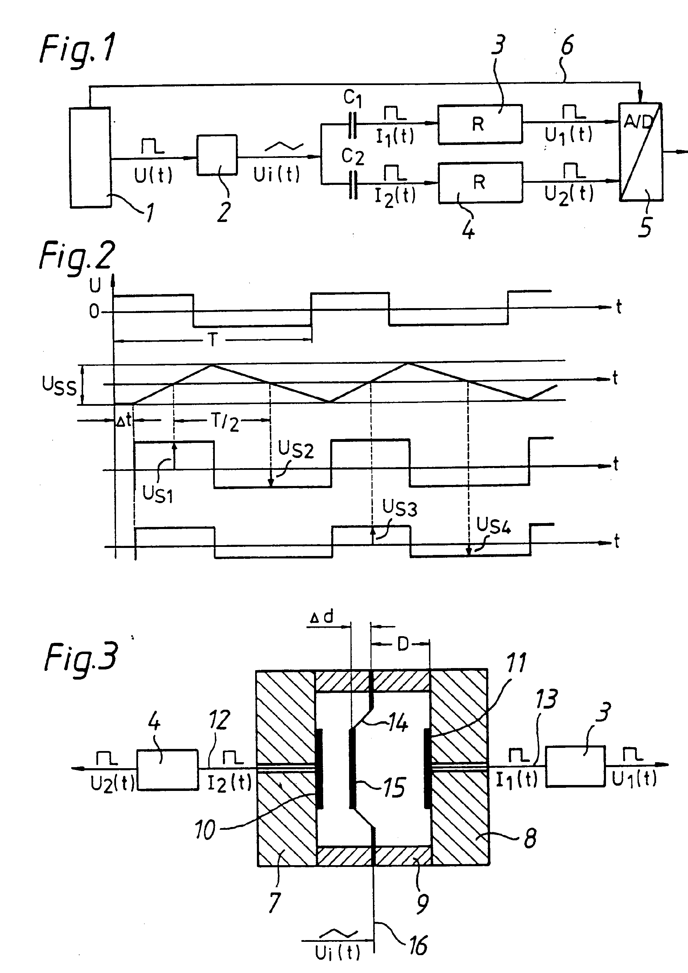

In Fig. 1 erzeugt ein Rechteckgenerator 1 Rechteckspannungsimpulse der Periodenlänge T. Die Rechteckimpulse müssen über mindestens zwei aufeinanderfolgende Signalperioden reproduzierbar sein, d.h. die Signalhöhen und die Dauer der einander entsprechenden Halbperioden müssen identisch sein. Es ist dabei nicht unbedingt erforderlich, daß die Dauer der Halbperioden genau T/2 ist. Darauf wird weiter unten noch eingegangen.

Die Rechteckimpulsfolge wird in einem Integrator 2 in eine Dreieckimpulsfolge $U_i(t)$ mit einem Spitze/Spitze-Wert $U_{ss}$ gewandelt. Sowohl die Erzeugung von Rechtecksignalen als auch die Umwandlung in Dreiecksignale sind mit elektronischen Standardbauelementen besonders einfach und wirtschaftlich zu realisieren. Das Dreiecksignal weist wohl definierte Flanken auf, die bei Bedarf sehr gut differenziert werden können, wobei das differenzierte Signal bei einer Differentiation ein Rechteck ist, dessen Signalhöhe ausschließlich von der Flankenneigung des Dreiecksignals abhängt.

Die Erfindung macht von dieser an sich bekannten Tatsache Gebrauch, da die miteinander zu vergleichenden Kapazitäten für eine eingeprägte Spannung ein reines Differenzierglied darstellen nach der Beziehung $I = C \cdot \dfrac{dUi}{dt}$.

Die miteinander zu vergleichenden Kapazitäten $C_1$ und $C_2$ sind mit ihrer einen Elektrode zusammengeschlossen und auf diese wird das Dreieckspannungssignal gegeben. Am Ausgang der beiden Kapazitäten entsteht dann jeweils ein Rechteckstromimpuls $I_1(t)$, $I_2(t)$, der in einem nachfolgenden Stromverstärker 3,4 in einen verstärkten Rechteckspannungsimpuls $U_1(t)$, $U_2(t)$ gewandelt wird. Da diese Spannungsimpulse direkt zur Meßwertermittlung dienen, sollte das Übertragungsverhalten der beiden Stromverstärker innerhalb einer bestimmten Toleranz gleich sein. Ist das nicht der Fall, so muß der unterschiedliche Verstärkungsfaktor nachfolgend berücksichtigt werden.

Vorzugsweise wird als Stromverstärker ein Transimpedanzverstärker gewählt, dessen Stromverstärkung ausschließlich durch die Größe seines Rückkopplungswiderstandes R bestimmt wird. Solche Transimpedanzverstärker können leicht für einen spezifizierten Gleichlauf ausgelegt werden, wobei die absolute Größe des Verstärkungsfaktors bei einem Vergleich der Signale $U_1(t)$ und $U_2(t)$ unbeachtlich ist.

Die Signale $U_1(t)$ und $U_2(t)$ werden in einem nachgeschalteten Funktionsblock 5 zunächst A/D-gewandelt. Der Mikroprozessor in diesem Block hält die jeweils zwei digitalen Amplitudenwerte aus jeder Impulsfolge $U_1(t)$ und $U_2(t)$ beginnend bei einem definierten ersten Zeitpunkt und dann im Abstand der halben Signalperiodenlänge T/2 für die weitere rechnerische Verknüpfung in dem Mikroprozessor im Funktionsblock 5 fest. Zur Synchronisation des vom Rechteckgenerator 1 erzeugten Rechtecksignals mit der im Mikroprozessor des Funktionsblocks 5 verarbeiteten Signalfolge erhält dieser über die Leitung 6 ein Taktsignal. Selbstverständich können der Rechteckgenerator 1, der Integrator 2 und der Funktionsblock 5 auch als integrierter Schaltkreis ausgeführt sein.

Es ist auch möglich, die jeweils zwei digitalen Amplitudenwerte zeitlich parallel zu gewinnen, wenn für jeden Meßpfad getrennte A/D-Wandler mit gleichen Eigenschaften vorgesehen werden. Die Signalspannung $U_i(t)$ braucht dann nur über eine Signalperiode die definierte Eigenschaft zu besitzen. Die Schaltung wird wegen des qualifiziert auszusuchenden zweiten A/D-Wandlers jedoch etwas teurer.

Die Entstehung und Abtastung der Signalfolgen soll anhand des Signalimpuls-Diagramms in Fig. 2 erläutert werden.

In der ersten Zeile des Diagramms ist der Verlauf der vom Rechteckgenerator 1 erzeugten Spannungsimpulse U(t) dargestellt. Die Periodenlänge soll T betragen. Es sind zwei aufeinanderfolgende Impulse dargestellt, die einen übereinstimmenden Amplituden- und Zeitverlauf haben. Mit den heute standardmäßig erhältlichen Signalgeneratoren lassen sich üblicherweise recht genau symmetrische Impulsfolgen erzeugen. In dem Ausführungsbeispiel soll jedoch von dem allgemeineren Fall ausgegangen werden, daß die beiden Periodenteile des Rechteckimpulses unterschiedlich lang sind, um zu zeigen, daß die erfindungsgemäße Schaltungsanordnung von diesen Toleranzen in der Signalerzeugung unabhängig ist.

In der zweiten Zeile des Diagramms ist der Verlauf des Dreiecksignals $U_i(t)$ am Ausgang des Integrators 2 dargestellt. Aufgrund einer Laufzeitverzögerung in dem Integrator 2 beginnt diese Impulsfolge um $\Delta t$ ver- schoben gegenüber dem Rechtecksignal am Eingang des Integrators 2. Die Periodenlänge ist auch hier T. Aufgrund der kürzeren ersten Halbperiode des Rechtecksignals ist die Anstiegsflanke des Dreiecksignals steiler als die abfallende Flanke.

In der dritten Zeile des Diagramms ist der Signalverlauf nach Differentiation an der Kapazität $C_1$ ($I_1(t)$ und $I_2(t)$) und Verstärkung im Stromverstärker 3 ($U_1(t)$ und $U_2(t)$) dargestellt. Entsprechend der steileren Anstiegsflanke des Dreiecksignals ist die Signal-Höhe der ersten Halbperiode des Signals größer als die Signal-Höhe der zweiten Halbperiode. Die Amplitudenbestimmung erfolgt in der ersten Halbperiode auf dem Nulldurchgang der Anstiegsflanke des Dreiecksignals. Bezogen auf den Startimpuls in Zeile 1 ist dies nach der Zeit $\Delta t + T/4$ bei vollkommen symmetrischem Rechtecksignal. Im dargestellten Fall liegt der erste Sampling-Zeitpunkt geringfügig früher. Der nächste Sampling-Zeitpunkt folgt dann jedoch im Abstand T/2.

Der Signalverlauf in der vierten Zeile des Diagramms entspricht dem in der dritten Zeile dargestellten, jedoch nach Differentiation an der Kapazität $C_2$ und Verstärkung im Stromverstärker 4. Unter der Vorausset- zung, daß $C_1 \neq C_2$, ist ergibt sich eine abweichende Signalamplitude. Die Abtastung der Signalamplituden erfolgt im zeitlichen Anschluß an die vorhergehenden wiederum im Abstand T/2. Als Meßwerte liegen danach die Amplitudenwerte $U_{s1}$, $U_{s2}$, $U_{s3}$, $U_{s4}$ vor.

Die Verknüpfung dieser Meßwerte zu einem Ausgabewert des Mikroprozessors im Funktionsblock 5, der dem Verhältnis der Kapazitätswerte $C_1$ und $C_2$ zueinander entspricht, erfolgt aufgrund folgender Überlegung.

Es ist $U_S = R \cdot C \cdot \dfrac{dUi}{dt}$.

Daraus folgt für

$$U_{s1} = R \cdot C_1 \cdot \frac{Uss}{T/2}$$

$$U_{s2} = R \cdot C_1 \cdot \frac{(-Uss)}{T/2}$$

$$U_{s3} = R \cdot C_2 \cdot \frac{Uss}{T/2}$$

$$U_{s4} = R \cdot C_2 \cdot \frac{(-Uss)}{T/2}$$

Durch Einsetzen ergibt sich:

$$\frac{(U_{s1} - U_{s2})}{(U_{s3} - U_{s4})} = \frac{C_1}{C_2}$$

Die Schaltungsanordnung ermöglicht daher unmittelbar die Ermittlung des Verhältnisses der Kapazitätswerte, wobei aufgrund des symmetrischen Aufbaus der Schaltungsanordnung alle konstanten Parameter der Bauelemente und der Meßsignalimpulse nicht in die Messung eingehen.

4

Fig. 3 zeigt als ein Anwendungsbeispiel einen Neigungs- bzw. Beschleunigungssensor, dessen Meßelemente zwei Kondensatorsysteme darstellen. Zwei Gehäuseteile 7,8 liegen jeweils auf einem Abstandsring 9 auf und werden über nicht weiter dargestellte Spannmittel zusammengehalten. Die Gehäuseteile 7 und 8 sind aus elektrisch isolierendem Material gefertigt. Innerhalb der durch die Teile 7, 8 und 9 gebildeten Sensorkammer sind die Gehäuseteile 7,8 mit Elektrodenplatten 10,11 belegt, von denen elektrische Anschlüsse 12,13 aus der Kammer herausgeführt sind.

In dem Abstandsring 9 ist eine an sich bekannte federnde Membran 14 eingespannt, die in ihrem zentralen Bereich eine Kondensatorplatte 15 trägt. Von der Kondensatorplatte 15 führt ebenfalls ein elektrischer Anschluß 16 aus der Sensorkammer heraus. Die Membran 14 mit der Kondensatorplatte 15 ist in der Ruhelage so angeordnet, daß sie im Abstand D symmetrisch zwischen den Elektrodenplatten 10,11 steht. Die Elektrodenplatte 10 bildet mit der Kondensatorplatte 15 eine Kapazität $C_1$ und die Elektrodenplatte 11 bildet mit der Kondensatorplatte 15 eine Kapazität $C_2$. Unter dem Einfluß der Schwerkraft oder der Trägheit kann die Membran 14 mit der Kondensatorplatte 15 in Richtung auf eine der Elektrodenplatten 10,11 um einen Betrag $\Delta d$ ausgelenkt werden, wodurch sich die Kapazitäten $C_1$ und $C_2$ verändern.

Die erfindungsgemäße Schaltungsanordnung kann mit Vorteil angewendet werden, um über die Veränderung des Verhältnisses der Kapazitäten $C_1, C_2$ zueinander den Betrag der Auslenkung d zu bestimmen. Im Gegensatz zu der aus DE-PS 25 23 446 bekannten Anordnung wird die Meßsignalspannung Ui(t) über den Anschluß 16 auf die Kondensatorplatte 15 eingegeben. Diese ist die für beide Kapazitäten $C_1, C_2$, gemeinsame Elektrode. Die Meßsignale $U_1(t)$ und $U_2(t)$ werden über die Leitungen 12,13 nach Verstärkung ausgegeben. Es ergibt sich folgender Zusammenhang aus den bekannten elektrostatischen Gesetzmäßigkeiten:

$$C_1 = \varepsilon \cdot \varepsilon_0 \cdot \frac{A}{(D + \Delta d)}$$

mit $\varepsilon$ = relative Dielektrizitätskonstante des Mediums in der Sensorkammer, das ist für Luft $\varepsilon \approx 1$,

$$C_2 = \varepsilon \cdot \varepsilon_0 \cdot \frac{A}{(D - \Delta d)}$$

$\varepsilon_0$ = absolute Dielektrizitätskonstante,
A = Elektrodenfläche
Durch Einsetzen ergibt sich daraus

$$\frac{C_2 - C_1}{C_1 + C_2} = \frac{\Delta d}{D} \ .$$

Setzt man die Kapazitäten $C_1$ und $C_2$ in Beziehung zu den entsprechenden Signalamplituden $Us_1$, $Us_2$, $Us_3$ und $Us_4$, so ergibt sich

$$\frac{\Delta d}{D} = \frac{(Us_3 - Us_4) - (Us_1 - Us_2)}{(Us_1 - Us_2) + (Us_3 - Us_4)}$$

Das neigungs- bzw. beschleunigungsabhängige Meßsignal ist also linear proportional zur Auslenkung der Kondensatorplatte 15.

## Patentansprüche

1. Schaltungsanordnung zur Messung des Quotienten der Kapazitätswerte $C_1$, $C_2$ von zwei Kondensatoren mit sehr kleinen Kapazitäten, wobei die zu vergleichenden Kondensatoren mit nur einer ihrer Elektroden zusammengeschaltet sind, die Kondensatoren mit einer periodischen Signalspannung beaufschlagt werden und durch Spannungsumwandlung die Quotienten bestimmt werden, **dadurch gekennzeichnet**, daß

a) an die miteinander verbundenen Elektroden der Kondensatoren eine an definierten Flanken differenzierbare, über mindestens zwei Signalperioden reproduzierbare Signalspannung $U_i(t)$ gelegt ist, und die beiden Kondensatoren in bezug auf die Signalquelle in parallelen Pfaden angeordnet sind,

aa) in denen jeweils die beiden anderen Elektroden der Kondensatoren mit einem Stromverstärker (3,4) verbunden sind,

b) die verstärkten Ausgangssignale $U_1(t)$, $U_2(t)$ der beiden Kondensatoren mit dem Eingang eines A/D-Wandlers verbunden sind, dem

bb) ein Funktionsblock (5) zugeordnet ist, der während einer ersten Signalperiode zwei digitale Amplitudenwerte $Us_1$, $Us_2$ der Ausgangssignale des einen Kondensators im Abstand einer halben Signalperiode (T/2) ermittelt und daran anschließend, ebenfalls im Abstand einer halben Signalperiode, während der zweiten Signalperiode zwei digitale Amplitudenwerte $Us_3$, $Us_4$ der Ausgangssignale des anderen Kondensators ermittelt, und

bc) das Kapazitätsverhältnis entsprechend

$$\frac{C_1}{C_2} = \frac{(Us_1 - Us_2)}{(Us_3 - Us_4)}$$

bestimmt und ausgibt.

2. Schaltungsanordnung zur Messung des Quotienten der Kapazitätswerte $C_1$, $C_2$ von zwei Kondensatoren mit sehr kleinen Kapazitäten, wobei die zu vergleichenden Kondensatoren mit nur einer ihrer Elektroden zusammengeschaltet sind, die Kondensatoren mit einer periodischen Signalspannung beaufschlagt werden und durch Spannungsumwandlung die Quotienten bestimmt werden, **dadurch gekennzeichnet**, daß

    a) an die miteinander verbundenen Elektroden der Kondensatoren eine an definierten Flanken differenzierbare Signalspannung $U_i(t)$ gelegt ist, so daß die beiden Kondensatoren in bezug auf die Signalquelle in parallelen Pfaden angeordnet sind,

    aa) in denen jeweils die beiden anderen Elektroden der Kondensatoren mit einem Stromverstärker (3,4) verbunden sind,

    b) die verstärkten Ausgangssignale $U_1(t)$, $U_2(t)$ der beiden Kondensatoren mit dem Eingang je eines A/D-Wandlers verbunden sind, denen

    bb) ein Funktionsblock (5) zugeordnet ist, der zeitlich parallel zwei digitale Amplitudenwerte $Us_1$, $Us_2$ der Ausgangssignale des einen Kondensators und zwei digitale Amplitudenwerte $Us_3$, $Us_4$ der Ausgangssignale des anderen Kondensators im Abstand je einer halben Signalperiode (T/2) ermittelt, und

    bc) das Kapazitätsverhältnis entsprechend

$$\frac{C_1}{C_2} = \frac{(Us_1 - Us_2)}{(Us_3 - Us_4)}$$

bestimmt und ausgibt.

3. Schaltungsanordnung nach Anspruch 1 oder 2, **dadurch gekennzeichnet**, daß ein frequenzstabiler Rechteckspannungsgenerator (1) mit nachgeschaltetem Integrator (2) zur Erzeugung eines Dreieckspannungssignals Ui(t) vorgesehen ist, das an die miteinander verbundenen Elektroden der Kondensatoren gelegt wird.

4. Schaltungsanordnung nach einem der vorhergehenden Ansprüche, **dadurch gekennzeichnet**, daß als Stromverstärker (3,4) zwei Transimpedanzverstärker mit spezifiziertem Gleichlauf vorgesehen sind.

5. Verwendung der Schaltungsanordnung nach einem der vorhergehenden Ansprüche in einem Gerät zur Neigungs- und/oder Beschleunigungsmessung, dessen Sensor aus zwei feststehenden Elektrodenplatten (10,11) und einer dazwischen beweglich angeordneten Kondensatorplatte (15) besteht.

6. Verwendung nach Anspruch 5, bei der an dem Sensor eine an definierten Flanken differenzierbare Signalspannung Ui(t) an die Kondensatorplatte (15) gelegt wird, die Elektrodenplatten (10,11) mit den Stromverstärkern (3,4) verbunden sind und die Ausgangssignale $U_1(t)$, $U_2(t)$ durch den Mikroprozessor (5) entsprechend

$$\frac{\Delta d}{D} = \frac{(Us_3 - Us_4) - (Us_1 - Us_2)}{(Us_1 - Us_2) + (Us_3 - Us_4)}$$

zu einem neigungs- bzw. beschleunigungsproportionalen Meßwert verknüpft werden, wobei D der Ruheabstand zwischen der Kondensatorplatte (15) und den Elektrodenplatten (10,11) und $\Delta d$ die Auslenkung der Kondensatorplatte (15) aus der Ruhelage ist.

## Claims

1. Circuit arrangement for the measurement of the quotients of the capacitance values $C_1$ and $C_2$ of two capacitors of very small capacitances, wherein the capacitors to be compared are connected together by only one of their electrodes, the capacitors are acted on by a periodic signal voltage and the quotients are ascertained through voltage conversion, characterised thereby, that

    a) a signal voltage $U_i(t)$, which is differentiatable at defined edges and reproducible over at least two signal periods, is applied to the electrodes, which are connected together, of the capacitors and both the capacitors are arranged in parallel paths with respect to the signal source,

    aa) in which paths each of both the other electrodes of the capacitors are connected with a respective current amplifier (3, 4),

    b) the amplified output signals $U_1(t)$ and $U_2(t)$ of both the capacitors are connected with the input of an analog-to-digital converter which is associated with

bb) a functions block (5), which during a first signal period ascertains two digital amplitude values $Us_1$ and $Us_2$ of the output signals of the one capacitor at the spacing of half a signal period (T/2) and subsequently thereto and during the second signal period ascertains two digital amplitude values $Us_3$ and $Us_4$ of the output signals of the other capacitor likewise at the spacing of half a signal period and

c) ascertains and issues the capacity ratio according to

$$\frac{C_1}{C_2} = \frac{(Us_1 - Us_2)}{(Us_3 - Us_4)}.$$

2. Circuit arrangement for the measurement of the quotients of the capacitance values $C_1$ and $C_2$ of the capacitors of very small capacitances, wherein the capacitors to be compared are connected together by only one of their electrodes,. the capacitors are acted on by a periodic signal voltage and the quotients are ascertained through voltage conversion, characterised thereby, that

a) a signal voltage $U_1(t)$, which is differentiatable at defined edges, is applied to the electrodes, which are connected together, of the capacitors so that both the capacitors are arranged in parallel paths with respect to the signal source,

aa) in which paths each of both the other electrodes of the capacitors are connected with a respective current amplifier (3, 4),

b) the amplified output signals $U_1(t)$ and $U_2(t)$ of both the capacitors are each connected with the output of a respective analog-to-digital converter which is associated with

bb) a functions block (5), which parallelly in time ascertains two digital amplitude values $Us_1$ and $Us_2$ of the output signals of the one capacitor and two digital amplitude values $Us_3$ and $Us_4$ of the output signals of the other capacitor each at the spacing of half a signal period (T/2) and

c) ascertains and issues the capacity ratio according to

$$\frac{C_1}{C_2} = \frac{(Us_1 - Us_2)}{(Us_3 - Us_4)}.$$

3. Circuit arrangement according to claim 1 or 2, characterised thereby, that a rectangular voltage generator (1) of stable frequency and with an integrator (2) connected therebehind is provided for the production of a triangular voltage signal Ui(t), which is applied to the electrodes, which are connected together, of the capacitors.

4. Circuit arrangement according to one of the preceding claims, characterised thereby, that two transfer characteristic amplifiers with specified ganging are provided as current amplifiers (3, 4).

5. Use of the circuit arrangement according to one of the preceding claims in an instrument which is for the measurement of inclination and/or acceleration and the sensor of which consists of two stationary electrode plates (10, 11) and a capacitor plate (15) arranged to be movable therebetween.

6. Use according to claim 5, in which a signal voltage $U_i(t)$, which is differentiatable at defined edges, is applied at the sensor to the capacitor plate (15), the electrode plates (10, 11) are connected with the current amplifiers (3, 4) and the output signals $U_1(t)$ and $U_2(t)$ are interlinked by the microprocessor (5) according to

$$\frac{\Delta d}{D} = \frac{(Us_3 - Us_4) - (Us_1 - Us_2)}{(Us_1 - Us_2) + (Us_3 - Us_4)}$$

into a measurement value which is proportional to inclination or acceleration, wherin D is the spacing at rest between the capacitor plate (15) and the electrode plates (10, 11) and $\Delta d$ is the deflection of the capacitor plate (15) out of the rest position.

## Revendications

1. Montage de circuit pour la mesure du quotient des valeurs de capacité $C_1$, $C_2$ de deux condensateurs ayant de très faibles capacités, dans lequel les condensateurs à comparer sont reliés l'un à l'autre par seulement l'une de leurs électrodes, les condensateurs sont chargés d'une tension de signal périodique et les quotients sont déterminés par conversion des tensions, caractérisés en ce que

a) aux électrodes réunies des condensateurs est appliquée une tension de signal $U_i(t)$ susceptible d'être différenciée à des flancs définis et reproductible sur au moins deux périodes de signal, et les deux condensateurs sont disposés par rapport à la source de signaux dans des voies parallèles,

aa) dans lesquels chaque fois l'une des deux électrodes des condensateurs est reliée à un amplificateur de courant (3, 4),

b) les signaux de sortie amplifiés $U_1(t)$, $U_2(t)$ des deux condensateurs sont appliqués à l'entrée d'un convertisseur A/D, auquel

bb) est associé un bloc de fonction (5) qui, pendant une première période de signal, détermine deux valeurs de mesure numérique $U_{s1}$, $U_{s2}$ des signaux de sortie de l'un des condensateurs à un écart d'une demi-période de signal (T/2) et détermine, ensuite, également à la distance d'une demi-période de signal, pendant la deuxième période de signal, deux valeurs d'amplitude numérique $U_{s3}$, $U_{s4}$ des signaux de sortie de l'autre condensateur, et

bc) détermine et sort le rapport des capacités correspondant à

$$\frac{C_1}{C_2} = \frac{(U_{s1} - U_{s2})}{(U_{s3} - U_{s4})}$$

2. Montage de circuit pour la mesure du quotient des valeurs de capacité $C_1$, $C_2$ de deux condensateurs ayant de très faibles capacités, dans lequel les condensateurs à comparer sont réunis par l'une de leurs électrodes, une tension de signal périodique est appliquée aux condensateurs et les quotients sont déterminés par conversion de tensions, caractérisé en ce que

a) aux électrodes réunies des condensateurs est appliquée une tension de signal $U_i(t)$ susceptible d'être différenciée aux flancs définis de façon que les deux condensateurs soient disposés par rapport à la source de signaux dans des voies parallèles,

aa) dans lesquelles les deux autres électrodes des condensateurs sont reliées respectivement à un amplificateur de courant (3, 4),

b) les signaux de sortie amplifiés $U_1(t)$, $U_2(t)$ des deux condensateurs sont appliqués chacun à l'entrée d'un convertisseur A/D auxquels

bb) est associé un bloc de fonction (5) qui détermine parallèlement dans le temps deux valeurs d'amplitude numériques $U_{s1}$, $U_{s2}$ des signaux de sortie de l'un des condensateurs et deux valeurs d'amplitude numériques $U_{s3}$, $U_{s4}$ des signaux de sortie de l'autre condensateur, à une distance chaque fois d'une demi-période de signal (T/2), et

bc) détermine et sort le rapport de capacités correspondant à

$$\frac{C_1}{C_2} = \frac{(U_{s1} - U_{s2})}{(U_{s3} - U_{s4})}$$

3. Montage de circuit selon la revendication 1 ou 2, caractérisé en ce qu'un générateur de tension rectangulaire (1) stable en fréquence avec intégrateur monté en aval (2) est prévu pour la production d'un signal de tension triangulaire Ui(t) qui est appliqué aux électrodes réunies des condensateurs.

4. Montage de circuit selon l'une des revendications précédentes, caractérisé en ce que deux amplificateurs de transimpédence aux aptitudes identiques spécifiées sont prévus comme amplificateurs de courant (3, 4).

5. Utilisation du montage de circuit selon l'une des revendications précédentes dans un appareil pour la mesure de l'inclinaison et/ou l'accélération, dont le capteur est formé par deux plaques d'électrode (10, 11) stationnaires et par une plaque de condensateur placée de façon mobile entre celles-ci.

6. Utilisation selon la revendication 5, pour laquelle une tension de signal Ui(t) susceptible d'être différenciée à des flancs définis est appliquée à la plaque de condensateur (15), les plaques d'électrode (10, 11) sont reliées aux amplificateurs de courant (3, 4) et les signaux de sortie U1(T), Ud(t) sont mis en relation par le microprocesseur (5) conformément à

$$\frac{\Delta d}{D} = \frac{(U_{s3} - U_{s4}) - (U_{s1} - U_{s2})}{(U_{s1} - U_{s2}) + (U_{s3} - U_{s4})}$$

pour obtenir une valeur de mesure proportionnelle à l'inclinaison ou à l'accélération, D étant la distance au repos entre la plaque de condensateur (15) et les plaques d'électrode (10, 11) et $\Delta d$ est l'excursion de la plaque de condensateur (15) de sa position au repos.

## Fig.1

## Fig.2

## Fig.3